## Europäisches Patentamt
## European Patent Office
## Office européen des brevets

(19)

(11) Numéro de publication: **0 181 664**
**B1**

(12) **FASCICULE DE BREVET EUROPEEN**

(45) Date de publication du fascicule du brevet: **12.09.90**

(51) Int. Cl.⁵: **H 03 K 3/356**

(21) Numéro de dépôt: **85201742.5**

(22) Date de dépôt: **28.10.85**

(54) Comparateur synchronisé.

(30) Priorité: **09.11.84 FR 8417096**

(43) Date de publication de la demande:
**21.05.86 Bulletin 86/21**

(45) Mention de la délivrance du brevet:
**12.09.90 Bulletin 90/37**

(84) Etats contractants désignés:
**DE FR GB IT NL**

(56) Documents cités:
**EP-A-0 036 743**
**EP-A-0 084 844**

**IEEE JOURNAL OF SOLID-STATE CIRCUITS, vol. SC-12, no. 5, octobre 1977, pages 497-501, IEEE, New York, US; T.R. O'CONNELL et al.: "Two static 4K clocked and nonclocked RAM designs"**

(73) Titulaire: **LABORATOIRES D'ELECTRONIQUE PHILIPS**
**3, Avenue Descartes**
**F-94450 Limeil-Brévannes (FR)**
(84) **FR**

(73) Titulaire: **N.V. Philips' Gloeilampenfabrieken**
**Groenewoudseweg 1**
**NL-5621 BA Eindhoven (NL)**
(84) **DE GB IT NL**

(72) Inventeur: **Ducourant, Thierry**
**Société Civile S.P.I.D. 209 rue de l'Université**
**F-75007 Paris (FR)**

(74) Mandataire: **Landousy, Christian et al**
**Société Civile S.P.I.D. 156, Boulevard Haussmann**
**F-75008 Paris (FR)**

Courier Press, Leamington Spa, England.

# EP 0 181 664 B1

**Description**

L'invention concerne un comparateur de tensions synchronisé, réalisé à l'aide de transistors dotés chacun d'une borne de commande, d'une première borne principale et d'une seconde borne principale, ce comparateur comprenant:

— un étage d'acquisition servant à comparer une tension d'entrée analogique à une tension de référence analogique et à fournir le résultat de la comparaison sous forme d'un signal intermédiaire et de son complémentaire, cet étage incluant deux transistors formant une première paire différentiel, la tension d'entrée et la tension de référence étant appliquées respectivement sur les bornes de commande de ces transistors dont les premières bornes principales présentent un point de connexion servant à amener un courant de réglage, et dont les secondes bornes principales sont couplées chacune par l'intermédiaire d'une charge à une première borne d'alimentation continue et fournissent respectivement le signal intermédiaire et son complémentaire;

— un étage mémoire couplé à l'étage d'acquisition, servant à produire les états logiques déterminés par les signaux issus des étages d'acquisition, cet étage mémoire incluant deux transistors formant une deuxième paire différentielle montée bascule bistable, les signaux issus de chacune des branches de l'étage d'acquisition étant appliqués respectivement sur les bornes de commande de ces transistors dont les premières bornes principales présentent un point de connexion et dont les secondes bornes principales sont couplées en croix aux bornes de commande des transistors de la deuxième paire, ces derniers points de connexion constituant les sorties de cet étage mémoire, ce comparateur étant en outre tel que:

— le point de connexion de la première paire différentielle est couplé à une deuxiéme borne d'alimentation continue par exemple la masse par l'intermédiaire d'un transistor source de courant;

— le point de connexion de la deuxième paire différentielle est porté directement au potentiel de la seconde borne d'alimentation continue;

— la deuxième paire différentielle est couplée à une troisième paire différentielle incluant deux transistors montés en parallèle sur les transistors de la deuxième paire différentielle et dont les bornes de commande reçoivent un signal d'horloge.

Un tel circuit peut être appliqué entre autres à un convertisseur analogique-numérique dit parallèle dans lequel le signal d'entrée analogique est amené aux entrées de plusieurs circuits comparateurs parallèles pour obtenir un signal de sortie numérique, circuits dans lesquels cette tension d'entrée est comparée avec une tension de référence qui est différente pour chaque circuit comparateur. Les signaux de sortie des circuits comparateurs sont convertis en un signal de sortie numérique à l'aide d'un dispositif de décodage. Le comparateur synchronisé utilisé dans de tels comparateurs analogiques parallèles présente en général une structure comme décrite dans le préambule.

Un tel circuit est connu de la publication dans "IEEE JOURNAL OF SOLID-STATE CIRCUITS, Vol. SC-12, N° 5, Octobre 1977, pp. 497—501" par T. R. O'CONNELL ET alii. intitulée "Two static 4K clocked and non-clocked RAM designs" p. 498, lignes 3—21, figure 2. Ce document décrit un comparateur de tensions, réalisé à l'aide de transistors dotés chacun d'une borne de commande, d'une première borne principale et d'une seconde borne principale, ce comparateur comprenant:

— un étage d'acquisition servant à comparer une tension d'entrée de référence analogique et à fournir le résultat de la comparaison sous forme d'un signal intermédiaire et son complémentaire, cet étage incluant deux transistors formant une première paire différentielle; la tension d'entrée et la tension de référence étant appliquées respectivement sur les bornes de commande de ces transistors dont les premières bornes principales présentent un point de connexion servant à amener un courant de réglage, et dont les secondes bornes principales sont couplées chacune par l'intermédiaire d'une charge à une première borne d'alimentation continue, fournissant respectivement le signal intermédiaire et son complémentaire;

— un étage mémoire couplé à l'étage d'acquisition, servant à produire les états logiques déterminés par les signaux issus des étages d'acquisition, cet étage mémoire incluant deux transistors formant une deuxième partie différentielle montée en bascule bristable, les signaux issus de chacune des branches de l'étage d'acquisition étant appliqués respectivement sur les bornes de commande de ces transistors dont les premières bornes principales présentent un point de connexion et dont les secondes bornes principales sont couplées en croix aux bornes de commande des transistors de la deuxième paire, ces derniers points de connexion constituant les sorties de cet étage mémoire;

Ce comparateur connu étant en outre tel que:

— le point de connexion de la première paire différentielle est couplé à une troisième borne d'alimentation continue représenté par le substrat, par l'intermédiaire d'un transistor source de courant;

— le point de connexion de la seconde paire différentielle est porté directement au potentiel d'une seconde borne d'alimentaton continue constituée par la masse;

— la deuxième paire différentielle est couplée à une troisième paire différentielle incluant deux transistors montés en parallèle sur les transistors de la deuxième paire différentielle et dont les bornes de commande reçoivent un signal d'horloge.

Un tel circuit est connu aussi du brevet des Etats-Unis d'Amérique N° 4.121.120. Ce second circuit connu, constitué de transistors bipolaires, comprend un étage d'acquisition formé d'une première paire de transistors couplés par leur émetteur et dont les bases reçoivent les signaux d'entrée. Ce circuit comprend

2

EP 0 181 664 B1

ensuite un étage amplificateur formé d'une seconde paire de transistors couplés par leurs émetteurs et dont les bases reçoivent les signaux issus des collecteurs des transistors de l'étage d'acquisition. Ce circuit comprend enfin deux mémoires, formés respectivement d'une troisième et d'une quatrième paire de transistors coupléspar leurs émetteurs, et dont les collecteurs sont couplés en croix respectivement d'une part aux collecteurs de la première paire de transistors, et d'autre part aux collecteurs de la deuxième paire de transistors. De plus, les émetteurs desdites première, deuxième, troisième et quatrième paire de transistors sont couplés chacun à une source de courant à travers un interrupteur formé par un transistor, les interrupteurs du circuit d'acquisition et du premier étage mémoire étant couplés par leurs émetteurs communs à une première source de courant, et les interrupteurs du circuit amplificateur et du second étage mémoire étant couplés par leurs émetteurs communs à une seconde source de courant. Enfin, lesdits interrupteurs sont commandés par des signaux d'horloge de manière à ce que le circuit d'acquisition et le second étage mémoire fonctionnement en même temps, précisément pendant que l'étage amplificateur et le premier étage mémoire ne sont pas en fonctionnement. Ce circuit connu fournit en sortie du premier étage mémoire un signal intermédiaire dont les états logiques suivent le signe de la différence entre le signal d'entrée et le signal de référence appliqués à l'entrée de l'étage d'acquisition, cette différence étant acquise sur le front de montée du signal d'horloge. L'étape amplificateur fournit en sortie du comparateur un signal numérique amplifié dont les états logiques suivent les états du signal intermédiaire, sont acquis sur un front de montée de l'horloge et sont maintenue par le second étage mémoire jusqu'à ce qu'un autre état apparaisse sur un front de montée.

Mais dans le but de réaliser de nouveaux systèmes logiques permettant des débits d'information toujours plus grands, de tels circuits doivent être transposés dans de nouvelles technologies comme par exemple une technologie incluant des transistors à effet de champ en arséniure de gallium.

En effet, dans le cas où par exemple un transistor à effet de champ à enrichissement de charge en arséniure de gallium est choisi comme élément actif d'un comparateur synchronisé, on peut s'attendre à une très grande vitesse de fonctionnement ainsi qu'à une très faible puissance consommée.

Cependant les conditions posées pour l'obtention de vitesse de fonctionnement élevées sont encore plus sévères que les conditions posées pour l'obtention de circuits à faible consommation.

C'est pourquoi la présente invention propose un nouveau comparateur synchronisé dont la vitesse de fonctionnement est augmentée, non seulement par l'adoption d'une technologie ultra-rapide mais encore par la structure même du circuit sans pour autant être pénalisé par une augmentation de la consommation.

Selon la présente invention ce but est atteint à l'aide d'un comparateur tel que décrit dans le préambule, caractérisé en ce que le transistor source de courant de la première paire différentielle est commandé par le signal d'horloge C.

Dans ces conditions l'étage mémoire n'est pas mis hors fonctionnement par coupure d'un générateur de courant, selon la méthode préconisée par l'art antérieur, mais par imposition directe de l'état logique O sur chacune des deux branches de la paire différentielle, au moyen des deux transistors placés en parallèle et commandés par le même signal d'horloge que la source de courant de l'étage d'acquisition avec lequel cet étage mémoire est couplé. Un fonctionnement plus rapide est ainsi obtenu.

Dans une forme de réalisation, ce comparateur est caractérisé en ce que les secondes bornes principales de la première paire différentielle, sont couplées respectivement aux bornes de commande de la deuxième paire différentielle chacune par l'intermédiaire d'une résistance de couplage.

Les résistances de couplage, à travers lesquelles les signaux issus de l'étage d'acquisition sont appliqués sur l'étage mémoire, minimisent les effets néfastes de la commutation entre ces étages.

L'invention sera mieux comprise à l'aide de la description suivante illustrée par les figures annexées dont:

La figure 1 qui donne le schéma symbolique par blocs du comparateur selon l'invention.

La figure 2 qui montre un circuit mettant en oeuvre l'invention dans la cas où il est réalisé avec des transistors à effet de champ à enrichissement.

La figure 3 qui montre l'évolution des signaux dans les différentes parties du circuit, en fonction des signaux d'horloge.

La figure 4 qui montre un circuit convertisseur analogique numérique réalisé à l'aide de comparateurs selon l'invention.

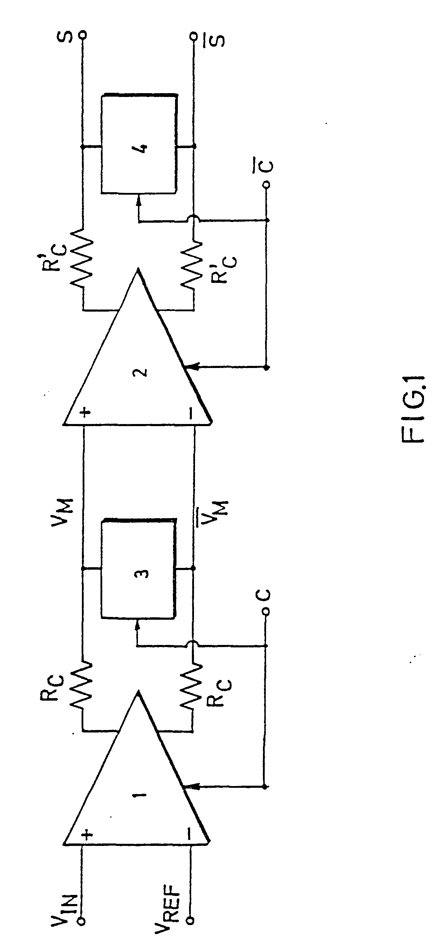

Tel que représenté sur la figure 1, le compatateur synchronisé conforme à l'invention, comprend un étant d'acquisition 1 couplé à un premier étage mémoire 3, par l'intermédiaire de résistances de couplage $R_c$ et un étage dit amplificateur 2 de structure analogue à l'étage d'acquisition 1 couplé à un second étage mémoire 4, par l'intermédiaire de résistances de couplage $R'_c$.

L'étage d'acquisition reçoit d'une part un signal analogique $V_{IN}$ et d'autre part un signal de référence analogique $V_{REF}$. Les sorties de l'étage d'acquisition couplées avec celles de l'étage mémoire fournissent un signal intermédiaire $V_M$ et son complémentaire $\overline{V_M}$.

L'étage d'acquisition 1 et l'étage mémoire 3 sont commandés par le même signal d'horloge C.

L'étage amplificateur 2 reçoit le signal intermédiaire $V_M$ et son complémentaire. Ses sorties couplées avec celles de l'étage mémoire 4 fournissent le signal numérique de sortie, en phase avec la valeur de la différence entre le signal d'entrée $V_{IN}$ et le signal de référence $V_{REF}$.

L'étage amplificateur 2 et l'étage mémoire 4 sont commandés par le même signal qui est le complémentaire C du signal d'horloge.

3

# EP 0 181 664 B1

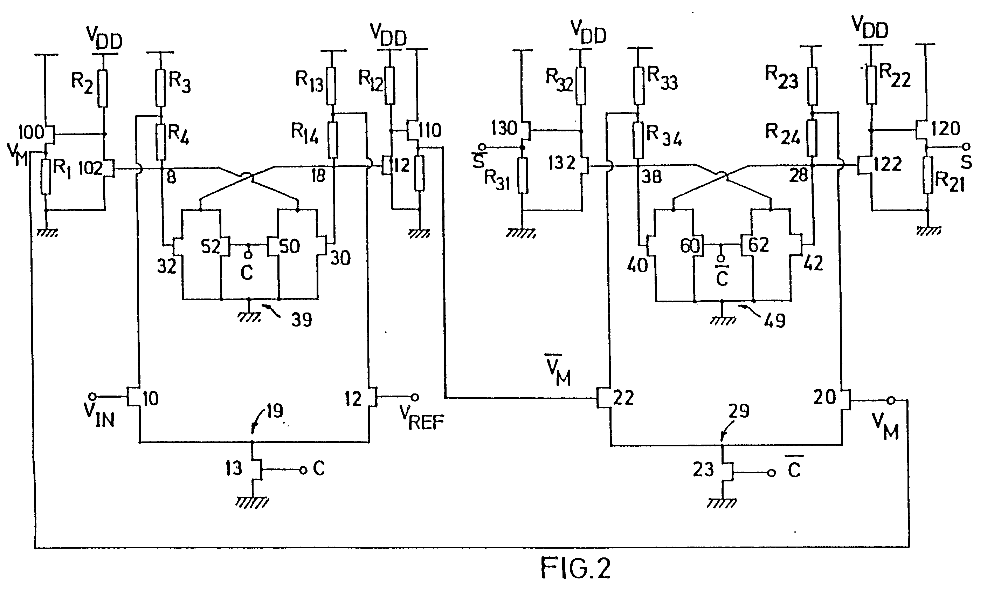

Dans une mise en oeuvre de l'invention, représentée sur la figure 2, le comparateur synchronisé conforme à l'invention est avantageusement réalisé à l'aide de transistors à effet de champ à enrichissement, par exemple en arséniure de gallium, transistors dont la tension de pincement $V_T > O$ entraîne qu'ils sont normalement pincés en l'absence de signal.

Tel que représenté sur la figure 2, l'étage d'acquisition est formé de deux transistors 10 et 12, couplés par les sources et dont les grilles reçoivent respectivement la tension d'entrée analogique $V_{IN}$ et la tension de référence analogique $V_{REF}$.

Les drains des transistors 10 et 12 sont portés à une première tension d'alimentation continue $V_{DD}$ par l'intermédiaire d'une résistance de charge respectivement $R_3$ et $R_{13}$.

Les sources des transistors 10 et 12 couplées au point de connexion 19 sont mises à une seconde tension d'alimentation continue par exemple la masse par l'intermédiaire d'un transistor de courant 13, commandé par le signal d'horloge C.

Le premier étage mémoire est formé de deux transistors 32 et 30 couplés par leurs sources au point de connexion 39. Ce point de connexion est directement porté au potentiel de la masse.

La commande de cet étage mémoire est assurée par deux transistors 52 et 50 respectivement montés en parallèle sur les transistors 32 et 30, et commandés par le signal d'horloge C.

Dans ces conditions, lorsque l'étape d'acquisition est mis en fonctionnement, l'étage mémoire se voit imposer directement l'état O. Or on sait que, pour obtenir un bon effet d'un tel étage d'acquisition couplé à étage mémoire, il est indispensable que la paire différentielle de l'étage mémoire soit mise *hors* fonctionnement au moment précis où la paire différentielle d'acquisition est mise *en* fonctionnement. S'il en était différemment, le circuit présenterait des instabilités. Or cette condition est souvent très difficile à remplir, particulièrement lorsque l'étage d'acquisition et l'étage mémoire sont commandés par des signaux d'horloge différents.

Selon la présente invention, cet inconvénient est évité du fait que l'étage mémoire et l'étage d'acquisition sont commandés par le même signal.

Un avantage supplémentaire est tiré du fait que l'état O est obtenu immédiatement. Ainsi le temps de propagation dans un transistor est gagné et le comparateur fonctionne plus rapidement.

Les grilles 8 et 18 des transistors 32 et 30, reçoivent, couplés en croix, les drains des transistors 30 et 50, et 32 et 52 respectivement. Les grilles des transistors 32 et 30 reçoivent en outre, par l'intermédiaire des résistances de couplage respectives $R_4$ et $R_{14}$ les signaux issus de l'étage d'acquisition.

Les points de connexion 8 et 18 constituent la sortie de cet ensemble étage d'acquisition-premier étage mémoire.

Sur ces points de connexions 8 et 18 sont placés respectivement des petits étages inverseurs-suiveurs. En particulier sur le point de connexion 8 l'étage inverseur est formé du transistor 102 et de la résistance de charge $R_2$ et l'étage suiveur est formé du transistor 100 et de la résistance $R_1$.

De même pour le point de connexion 18, l'étage inverseur est formé du transistor 112 et de la résistance $R_{12}$, et l'étage suiveur, du transistor 110 et de la résistance $R_{11}$.

L'étage inverseur sert à augmenter le niveau haut de sortie de l'étage mémoire. L'étage suiveur sert à diminuer l'impédance de sortie de l'ensemble étage d'acquisition-étage mémoire.

L'ensemble étage amplificateur-second étage mémoire présente exactement la même structure et le même principe de fonctionnement que l'ensemble étage d'acquisition-premier étage mémoire. Seuls les transistors et les résistances de couplage ou de charge peuvent présenter des valeurs légèrement différentes pour une meilleure adaptation.

L'étage amplificateur est donc formé des deux transistors 22 et 20, couplés par les sources et dont les grilles reçoivent respectivement le signal intermédiaire $V_M$ et son complémentaire $\overline{V_M}$ disponibles sur les sources des transistors 100 et 110 des étages suiveurs précédemment décrits. Les sources couplées au point de connexion 29 sont mises par exemple à la masse par l'intermédiaire d'un transistor source de courant 23, commandé par le signal d'horloge complémentaire $\overline{C}$.

Les drains des transistors 22 et 20 sont portées à la première tension d'alimentation continue $V_{DD}$ par l'intermédiaire d'une résistance de charge respectivement $R_{33}$ et $R_{23}$.

Le second étage mémoire est formé de deux transistors 40 et 42 couplés par leurs sources au point de connexion 49. Ce point de connexion est directement porté au potentiel de la masse.

La commande de cet étage mémoire est assurée par deux transistors 60 et 62 respectivement montés en parallèle sur les transistors 40 et 42, et commandés par le signal d'horloge complémentaire $\overline{C}$.

Dans ces conditions, lorsque l'étage amplificateur est mis en fonctionnement, l'étage mémoire se voit imposer directement l'état O.

Les grilles 38 et 28 des transistors 40 et 42, reçoivent, couplés en croix les drains des transistors 42 et 62, et 40 et 60 respectivement. Les grilles des transistors 40 et 42 reçoivent en outre, par l'intermédiaire des résistance de couplage respectives $R_{34}$ et $R_{24}$ les signaux issus de l'étage amplificateur.

Les points de connexion 38 et 28 constituent la sortie de cet ensemble étage amplificateur-second étage mémoire.

Sur ces points de connexions 38 et 28 sont placés respectivement des petits étages inverseurs-suiveurs. En particulier sur le point de connexion 38 l'étage inverseur est formé du transistor 132 et de la résistance de charge $R_{32}$ et l'étage suiveur est formé du transistor 130 et de la résistance $R_{31}$.

De même pour le point de connexion 28, l'étage inverseur est formé du transistor 122 et de la

4

# EP 0 181 664 B1

résistance $R_{23}$, et l'étage suiveur, du transistor 120 et de la résistance $R_{21}$.

Le signal numérique de sortie du comparateur est disponible sur la source du transistor suiveur 120, et son complémentaire $\overline{S}$ est disponible sur la source du transistor suiveur 130.

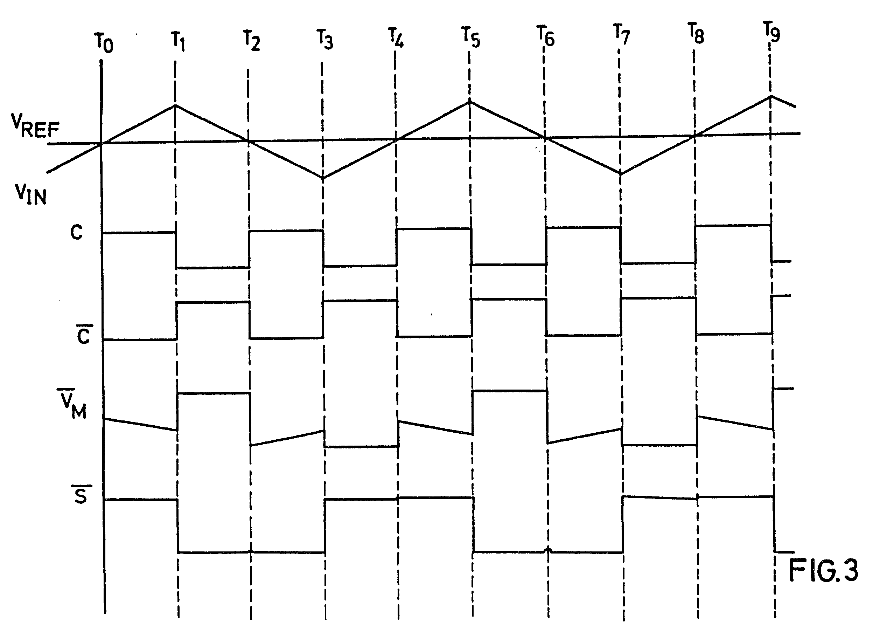

Dans ces conditions, comme il est montré sur la figure 3, lorsque la différence entre le signal d'entrée analogique $V_{IN}$ et le signal de référence analogique $V_{REF}$ appliquée sur l'étage d'acquisition est positive et qu'arrive le front descendant du signal d'horloge C au temps $T_1$, le signal complémentaire $\overline{V_M}$ par exemple est en mémorisation à l'état haut et le signal de sortie complémentaire $\overline{S}$ passe à l'état bas.

Puis lorsqu'arrive au temps $T_2$ un front montant de l'horloge C, la différence devenant négative, le signal complémentaire $\overline{V_M}$ passe en acquisition à l'état bas, et le signal de sortie complémentaire $\overline{S}$ passe en mémorisation à l'état bas.

Sur le front descendant de l'horloge, au temps $T_3$, la différence étant toujours négative, le signal intermédiaire complémentaire $V_M$ est en memorisation à l'état bas et le signal de sortie complémentaire S est en acquisition à l'état haut.

Enfin au temps $T_4$, la différence devenant positive sur un front de montée de l'horloge C, le signal de sortie complémentaire passe en mémorisation a l'état haut.

Ainsi le signal de sortie S suit en phase le signe de la différence entre le signal d'entrée $V_{IN}$ et le signal de référence $V_{REF}$.

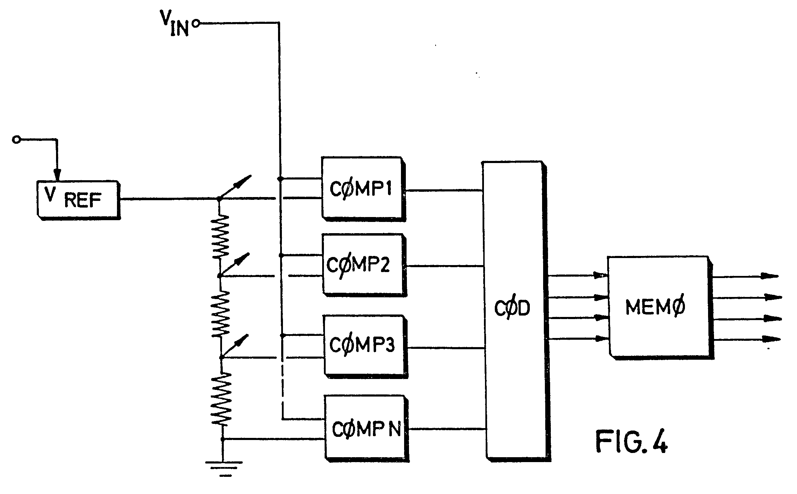

Le convertisseur analogique-numérique représenté sur la figure 4 comporte plusieurs comparateurs montés en parallèle (COMP 1, . . . COMPN,) qui sont munis chacun de deux entrées. La tension d'entrée analogique $V_{IN}$ à convenir est amenée à une entrée de chaque comparateur. A l'autre entrée de chaque comparateur est amenée une tension de référence obtenue par application d'une tension de référence aux bornes du montage en série de plusieurs résistances. Dans le cas où toutes les résistances sont égales, on obtient une progression géométrique des tensions de référence, le rapport relatif des tensions de référence étant égal à $V_{REF}/2$. Les diverses tension de référence présentent un numéro de rang 1, 2, . . ., i, $2^{n-1}$, $2^n$ constituent alors une série suivante $V_{REF}/2^n$, $V_{REF}/2^{n-1}$, . . . $V_{REF}^n$ ces dernières tensions n'étant utilisées que pour indiquer un bit de dépassement. Les sorties des comparateurs sont connectées aux entrées d'un dispositif de codage logique (COD), qui délivre un signal numérique de n bits à la sortie suivant un code quelconque, qui peut être par exemple le code de Gray. La structure du dispositif de codage est tributaire du code requis, mais n'est pas ici décrite en détail, du fait que ce dispositif de codage ne fait pas, à proprement dit, partie de l'invention. Une mémoire (MEMO) peut être couplée à la sortie de dispositif de codage pour conserver l'information du dispositif de codage pendant au moins une partie de la période d'horloge permettant la synchronisation des comparateurs. Le signal d'horloge nécessaire pour le comparateur et les mémoires est délivré par un circuit externe. Ces circuits peuvent être intégrés sur le même substrat semi-conducteur.

Dans le cas où le comparateur décrit, est réalisé à l'aide de transistors en arséniure de gallium, à grille Schottky, les tensions $V_{IN}$, $V_{REF}$, $V_M$, $\overline{V_M}$, S et $\overline{S}$ sont de 0,6 V pour le niveau haut et 0,1 V pour le niveau bas.

Les tensions de seuil des transistors sont $V_T = 0,1$ V.

Les tensions d'alimentation continues sont:

pour la première $V_{DD} = 2$ V

pour la seconde: la masse

Les caractéristiques des largeur de grille L et des valeurs des résistances R sont rassemblées dans le tableau suivant:

5

## TABLEAU I

| Transistors | | Résistances | |
|---|---|---|---|
| N° | L en m | N° | R |
| 10,12 | 50 | $R_4$, $R_{14}$ | 1,8 k |
| 32,30 | 20 | $R_3$, $R_{13}$ | 2,2 k |
| 52,50 | 20 | $R_2$, $R_{12}$ | 7 k |
| 102,112 | 10 | $R_1$, $R_{11}$ | 3 k |
| 100,110 | 30 | | |
| 13 | 30 | | |
| 22,20 | 25 | $R_{34}$, $R_{24}$ | 1,6 k |
| 40,42 | 20 | $R_{33}$, $R_{23}$ | 1,6 k |
| 60,62 | 20 | $R_{32}$, $R_{22}$ | 7 k |
| 122,132 | 10 | $R_{31}$, $R_{21}$ | 3 k |
| 130,120 | 30 | | |
| 23 | 30 | | |

L'utilisation d'un comparateur identique pour la réalisation d'un convertisseur analogique-numérique signifie également un avantage pour la réalisation sous forme d'un circuit intégré.

Il est évident pour l'homme de l'art que de nombreuses variantes peuvent être réalisées sans sortir du cadre de la présente invention comme défini dans les revendications ci-annexées.

## Revendications

1. Comparateur de tensions, réalisé à l'aide de transistors dotés chacun d'une borne de commande, d'une première borne principale et d'une seconde borne principale, ce comparateur comprenant:

— un étage d'acquisition servant à comparer une tension d'entrée analogique ($V_{IN}$) à une tension de référence analogique ($V_{REF}$) et à fournir le résultat de la comparaison sous forme d'un signal intermédiaire ($V_M$) et son complémentaire ($\overline{V_M}$), cet étage incluant deux transistors (10, 12) formant une première paire différentielle, la tension d'entrée ($V_{IN}$) et la tension de référence ($V_{REF}$) étant appliquées respectivement sur les bornes de commande de ces transistors dont les premières bornes principales présentent un point de connexion (19) servant à amener un courant de réglage, et dont les secondes bornes principales sont couplées chacune par l'intermédiaire d'une charge $R_3$, $R_{13}$ à une première borne d'alimentation continue ($V_{DD}$) et fournissent respectivement le signal intermédiaire et son complémentaire;

— un étage mémoire couplé à l'étage d'acquisition, servant à produire les états logiques déterminés par les signaux issus des étages d'acquisition, cet étage mémoire incluant deux transistors (32, 30) formant une deuxième paire différentielle montée bascule bistable, les signaux issus de chacune des branches de l'étage d'acquisition étant appliqués respectivement sur les bornes de commande de ses transistors dont les premières bornes principales présentent un point de connexion (39) et dont les secondes bornes principales sont couplées en croix aux bornes de commande des transistors de la deuxième paire, ces derniers points de connexion constituant les sorties (8, 18) de cet étage mémoire, ce comparateur étant en outre tel que:

— le point de connexion (19) de la première paire différentielle est couplé à une deuxième borne d'alimentation continue par exemple la masse par l'intermédiaire d'un transistor source de courant (13);

— le point de connexion (39) de la deuxième paire différentielle est porté directement au potentiel de la second borne d'alimentation continue;

— la deuxième paire différentielle est couplées à une troisième paire différentielle incluant deux transistors (52, 50) montés en parallèle sur les transistors (32, 30) de la deuxième paire différentielle et dont les bornes de commande reçoivent un signal d'horloge (C) caractérisé en ce que le transistor source de courant (13) de la première paire différentielle est commandé par la signal d'horloge (C).

2. Comparateur selon la revendication 1, caractérisé en ce que les secondes bornes principales de la première paire différentielle, sont couplées respectivement aux bornes de commande de la deuxième paire différentielle chacune par l'intermédiaire d'une résistance de couplage.

3. Comparateur selon l'une des revendications 1 ou 2, caractérisé en ce que les charges ($R_3$, $R_{13}$) sont de type résistif.

4. Comparateur selon l'une des revendications 1 à 3, caractérisé en ce qu'un étage inverseur-suiveur est placé sur chacune des sorties du premier étage mémoire.

5. Comparateur selon la revendication 4, caractérisé en ce que chaque étage inverseur suiveur est formé d'un premier transistor à rôle d'inverseur dont la borne de commande reçoit un des signaux de sortie de l'étage mémoire, dont la première borne principale est reliée à la seconde borne d'alimentation continue par exemple la masse, dont la seconde borne principale est reliée à la première borne d'alimentation continue ($V_{DD}$) par l'intermédiaire d'une charge résistive, la sortie de l'inverseur étant disponible sur la seconde borne principale dudit premier transistor, et est formé d'un second transistor à rôle de suiveur, dont la borne de commande reçoit le signal issu de l'inverseur, dont la seconde borne principale est reliée à seconde borne d'alimentation continue par l'intermédiaire d'une résistance, dont la seconde borne principale est reliée à la première borne d'alimentation continue ($V_{DD}$) les signaux de sortie de chaque étage inverseur-suiveur étant disponibles sur la première borne principale du transistor-suiveur.

6. Comparateur selon la revendication 5, caractérisé en ce que les signaux numériques ($V_M$, $\overline{V_M}$) issus de l'ensemble étage d'acquisition-étage mémoire sont disponibles en sortie des étages inverseurs-suiveurs placés en sortie du premier étage mémoire.

7. Comparateur selon l'une des revendications précédentes caractérisé en ce que les transistors sont du type à effet de champ à enrichissement par exemple en arséniure de gallium.

8. Système de comparateurs comprenant un comparateur selon l'une des revendications précédentes, caractérisé en ce que le système présente en outre un second comparateur de même structure que le premier comparateur, second comparateur dont:

— l'étage d'acquisition constitue un étage amplificateur, servant à amplifier les états logiques du signal numérique et son complémentaire du premier comparateur;

— l'étage mémoire couplé à l'étage amplificateur sert à retenir les états logiques déterminés par les signaux issus de l'étage amplificateur;

— les bornes de commande des transistors de la troisième paire différentielle reçoivent le signal complémentaire ($7\overline{C}$) du signal d'horloge.

9. Système de comparateurs selon la revendication 8, caractérisé en ce que le transistor source de courant (23) de la première paire différentielle du second comparateur est commandé par le signal complémentaire ($\overline{C}$) du signal d'horloge.

10. Convertisseur analogique-numérique, caractérisé en ce que pour obtenir un signal de sortie numérique à n bits, le convertisseur analogique numérique est muni de $2^n$ comparateurs synchronisés montés en parallèle, selon l'une des revendications précédentes, et en ce que à une entrée de chaque comparateur est amené le signal d'entrée analogique à convertir et à l'autre entrée de chaque comparateur une tension de référence différente, les sorties des comparateurs étant connectées à un dispositif de codage, dont la sortie délivre le signal de sortie numérique à n bits.

**Patentansprüche**

1. Spannungskomparator, der aus Transistoren aufgebaut ist, die mit je einem Steueranschluß, einem ersten Hauptanschluß und einem zweiten Hauptanschluß versehen sind, wobei der Komparator folgende Elemente enthält:

— eine Erfassungsstuffe zum Vergleichen einer analogen Eingangsspannung ($V_{IN}$) mit einer analogen Bezugsspannung ($V_{REF}$) und zum Ausgeben des Vergleichsergebnisses als eines Zwischensignals ($V_M$) und seines Komplementsignals ($\overline{V_M}$), wobei die Stufe zwei Transistoren (10, 12) besitzt, die ein erstes Differenzpaar bilden, den Steueranschlüssen dieser Transistoren jeweils die Eingangsspannung ($V_{IN}$) und die Bezugsspannung ($V_{REF}$) zugeführt werden, deren erste Hauptanschlüsse einen Verbindungspunkt (19) zum Zuführen eines Regelstroms darstellen und deren zweite Hauptanschlüsse über je eine Belastung $R_3$, $R_{13}$ mit einem ersten Gleichstromsspeiseanschluß ($V_{DD}$) gekoppelt sind und das Zwischensignal bzw. sein Komplementsignal ausgeben;

— eine mit der Erfassungsstufe verbundene Speicherstufe zum Verwirklichen der logischen Zustände, die die von den Erfassungsstufen ausgegebenen Signale bestimmen, wobei diese Speicherstufe zwei Transistoren (32, 30) enthält, die ein zweites Differenzpaar in Flipflopschaltung bilden, den Steueranschlüssen dieser Transistoren jeweils die von jedem der Abzweige der Erfassungsstufe ausgegebenen Signale zugeführt werden, deren erste Hauptanschlüsse einen Verbindungspunkt (39) darstellen und deren zweite Hauptanschlüsse mit den Steueranschlüssen der Transistoren des zweiten Paares kreuzweise gekoppelt sind, und diese letzten Verbindungspunkte die Ausgänge (8, 18) dieser Speicherstufe bilden, wobei dieser Komparator außerdem derart ausgelegt ist, daß

— der Verbindungspunkt (19) des ersten Differenzpaares über einen Stromquellentransistor (13) mit

7

EP 0 181 664 B1

einem zweiten Gleichstromspeiseanschluß beispielsweise der Masse verbunden ist;

— der Verbindungspunkt (39) des zweiten Differenzpaares direkt das Potential des zweiten Gleichstromspeiseanschlusses führt;

— das zweite Differenzpaar mit einem dritten Differenzpaar verbunden ist, das Transistoren (52, 50) in Parallelschaltung mit den Transistoren (32, 30) des zweiten Differenzpaares enthält und deren Steueranschlüsse ein Taktsignal (C) empfangen, dadurch gekennzeichnet, daß der Stromquellentransistor (13) des ersten Differenzpaares durch das Taktsignal (C) gesteuert wird.

2. Komparator nach Anspruch 1, dadurch gekennzeichnet, daß die zweiten Hauptanschlüsse des ersten Differenzpaares jeweils mit dem Steueranschlüssen des zweiten Differenzpaares über je einen Verbindungswiderstand verbunden sind.

3. Komparator nach einem der Ansprüche 1 oder 2, dadurch gekennzeichnet, daß die Belastungen ($R_3$, $R_{13}$) vom Widerstandstyp sind.

4. Komparator nach einem der Ansprüche 1 oder 3, dadurch gekennzeichnet, daß eine Inverter-Folgerstufe in jedem der Ausgänge der ersten Speicherstufe angeordnet ist.

5. Komparator nach Anspruch 4, dadurch gekennzeichnet, daß jede Inverter-Folgerstufe aus einem als Inverter dienenden ersten Transistor besteht, dessen Steueranschluß eines der Ausgangssignale der Speicherstufe empfängt, dessen erster Hauptanschluß mit dem zweiten gleichstromspeisanschluß zum Beispiel der Masse verbunden ist, dessen zweiter Hauptanschluß mit dem ersten Gleichstromspeiseanschluß ($V_{DD}$) über eine Widerstandsbelastung verbunden ist, wobei das Ausgangssignal des Inverters am zweiten Hauptanschluß des ersten Transistors abgreifbar ist, und aus einem als Folger dienenden zweiten Transistor besteht, dessen Steueranschluß das vom Inverter ausgegebene Signal empfängt, dessen zweiter Hauptanschluß über einen Widerstand mit dem zeiten Gleichstromspeiseanschluß verbunden ist, dessen zweiter Hauptanschluß mit dem ersten Gleichstromspeiseanschluß ($V_{DD}$) verbunden ist, wobei die Ausgangssignale jeder Inverter-Folger-Stufe am ersten Hauptanschluß des Transistorfolgers abgreifbar sind.

6. Komparator nach Anspruch 5, dadurch gekennzeichnet, daß die von der Kombination Erfassungsstufe/Speicherstufe ausgegebenen digitalen Signale ($V_M$, $\overline{V_M}$) am Ausgang der am Ausgang der ersten Speicherstufe angeordneten Inverter-Folger-Stufen abgreifbar sind.

7. Komparator nach einem oder mehreren der vorangehenden Ansprüche, dadurch gekennzeichnet, daß die Transistoren Feldeffekttransistoren vom Anreicherungstyp beispielsweise aus Galliumarsenid sind.

8. Komparatorensystem mit einem Komparator nach einem oder mehreren der vorangehenden Ansprüche, dadurch gekennzeichnet, daß das System außerdem einen zweiten Komparator derselben Struktur wie die des ersten Komparators enthält, wobei im zweiten Komparator

— die Erfassungsstufe eine Verstärkerstufe zum Verstärken der logischen Zustände des digitalen Signals und seines Komplementsignals des ersten Komparators darstellt;

— die mit der Verstärkerstufe verbundene Speicherstufe zum Festhalten der logischen Zustände dient, die durch die ausgegebenen Signale der Verstärkerstufe bestimmt werden;

— die Steueranschlüsse der Transistoren des dritten Differenzpaares das Komplementsignal ($\overline{C}$) des Taktsignals empfangen.

9. Komparatorensystem nach Anspruch 8, dadurch gekennzeichnet, daß der Stromquellentransistor Anspruch (23) des ersten Differenzpaares des zweiten Komparators vom Komplementsignal ($\overline{C}$) des Taktsignals gesteuert wird.

10. Analog/Digital-Wandler, dadurch gekennzeichnet, daß zum Erhalten eine digitalen Ausgangssignals von n Bits der Analog/Digital-Wandler mit $2^n$ parallelgeschalteten synchronisierten Komparatoren nach einem oder mehreren der vorangehenden Ansprüche ausgerüstet ist, und daß einem Eingang jedes Komparators das umzusetzende analoge Eingangssignal und dem anderen Eingang jedes Komparators eine abweichende Bezugsspannung zugeführt werden, wobei die Komparatorausgänge an einen Coder angeschlossen sind, dessen Ausgang das digitale Ausgangssignal von n Bits führt.

**Claims**

1. A voltage comparator realised by means of transistors which each have a control terminal, a first main terminal and a second main terminal, which comparator comprises:

— an acquisition stage which serves for comparing an analog input voltage ($V_{IN}$) with an analog reference voltage ($V_{REF}$) and for supplying the result of the comparison in the form of an intermediate signal ($V_M$) and its complement ($\overline{V_M}$), which stage comprises two transistors (10, 12) arranged as a differential pair, the input voltage ($V_{IN}$) and the reference voltage ($V_{REF}$) being applied to the respective control terminals of said transistors, whose first main terminals have a common node (19) for receiving a control current and whose second main terminals are each coupled to a first d.c. supply terminal ($V_{DD}$) via a load ($R_3$, $R_{13}$) and supply the intermediate signal and its complement respectively;

— a memory stage coupled to the acquisition stage, which memory stage serves for generating logic states in conformity with the output signals from the acquisition stage, which memory stage comprises two transistors arranged as a second differential pair forming a bistable multivibrator, the signals received from each of the branches of the acquisition stage being applied to the respective control terminals of said

8

memory stage transistors, shows first main terminals have a common node (39) and whose second main terminals are cross-coupled to the control terminals of the transistors of the second pair to form the outputs (8, 18) of said memory stage, said comparator moreover being such that

— the node (19) of the first differential pair is coupled to a second d.c. supply terminal, for example earth, *via* a current-source transistor (13),

— the node (39) of the second differential pair is brought directly at the potential of the second d.c. supply terminal,

— the second differential pair is coupled to a third differential pair comprising two transistors (52, 50) arranged in parallel with the transistors (32, 30) of the second differential pair, a clock signal (C) being applied to the control terminals of said third differential pair, characterized in that the current-source transistor (13) of the first differential pair is controlled by the clock signal (C).

2. A comparator as claimed in Claim 1, characterized in that the second main terminals of the first differential pair are each coupled to the respective control terminals of the second differential pair *via* a coupling resistor each.

3. A comparator as claimed in Claim 1 or 2, characterized in that the loads ($R_3$, $R_{13}$) are of the resistive type.

4. A comparator as claimed in any one of the Claims 1 to 3, characterized in that an inverter/follower stage is connected to each of the outputs of the first memory stage.

5. A comparator as claimed in Claim 4, characterized in that each inverter/follower stage comprises a first transistor operating as an inverter, whose control terminal receives one of the output signals from the memory stage whose first main terminal is connected to the second d.c. supply terminal, for example earth, and whose second main terminal is connected to the first d.c. supply terminal ($V_{DD}$) *via* a resistive load, the output signal of the inverter appearing on the second main terminal of said first transistor, and comprises a second transistor operating as a follower, whose control terminal receives the signal from the inverter, whose first main terminal is connected to the second d.c. supply terminal *via* a resistor, and whose second main terminal is connected to the first d.c. supply terminal ($V_{DD}$), the output signals of each inverter/follower stage appearing on the first main terminal of the follower transistor.

6. A comparator as claimed in Claim 5, characterized in that the digital signals ($V_M$, $\overline{V_M}$) from the combination of the acquisition stage and memory stage are available on the outputs of the inverter/follower stages connected to the output of the first memory stage.

7. A comparator as claimed in any one of the preceding Claims, characterized in that the transistors are enhancement-type field-effect transistors, for example gallium-arsenide transistors.

8. A comparator arrangement comprising a comparator as claimed in any one of the preceding Claims, characterized in that the arrangement further comprises a second comparator of the same structure as the first comparator, in which second comparator

— the acquisition stage constitutes an amplifier stage which serves to amplify the logic states of the digital signal and its complement received from the first comparator,

— the memory stage, which is coupled to the amplifier stage, serves to store the logic states determined by the signals from the amplifier stage,

— the control terminals of the transistors of the third differential pair receive the complementary clock signal ($\overline{C}$).

9. A comparator arrangement as claimed in Claim 8, characterized in that the current-source transistor (23) of the first differential pair of the second comparator is controlled by the complementary clock signal ($\overline{C}$).

10. An analog-to-digital converter, characterized in that, for obtaining an n-bit digital output signal, the analog-to-digital converter comprises $2^n$ parallel-connected synchronized comparators as claimed in any one of the preceding Claims, and in that the analog input signal to be converted is applied to one input of each comparator and a different reference voltage to the other input of each comparator, the outputs of the comparators being connected to an encoding device whose output supplies the n-bit digital output signal.

FIG.1

FIG.2

FIG.3

EP 0 181 664 B1

FIG.4